# EUROPEAN PATENT APPLICATION

(11) **EP 4 210 109 A1**
(43) Date of publication of application: **12.07.2023**
(21) Application number: 22151047.2
(22) Date of filing: 11.01.2022
(51) Int. Cl.: H01L 29/40, H01L 29/423, H01L 29/78, H01L 21/336, H01L 29/66

(54) **SILICON CHIP PACKAGE STRUCTURE AND METHOD OF MANUFACTURING THEREOF**

(71) Applicant: Nexperia B.V., 6534 AB Nijmegen (NL)
(72) Inventor: Khaund, Chinmoy, 22529 Hamburg (DE); Hung, Pei Heng, 22529 Hamburg (DE); Schoer, Gerrit, 22529 Hamburg (DE)
(74) Representative: Pjanovic, Ilija

(57) **Abstract**

The present disclosure presents a silicon chip package structure (100) in particular a metal-oxide-semiconductor field-effect transistor (MOSFET), the silicon chip package structure (100) comprising: a silicon substrate having a first substrate surface side (111) and a second substrate surface side opposite to the first substrate surface side (111), a silicon body (120) having a first body surface side (121) and a second body surface side (122) opposite to the first body surface side (121) , and provided with its second body surface side (122) to the first substrate surface side (111) of the silicon substrate, the silicon body (120) comprising an epitaxial layer (EPI) at its second body surface side functioning as a channel and a body well layer at its first body surface side functioning as a drift region, at least one drain (D) , at least one source (S) and at least one gate (G), wherein the source (S) and the drain (D) are provided at the first body surface side (121) of the silicon body (120) and the gate (G) is formed as a trench (130) positioned between the source (S) and the drain (D) and extending from the first body surface side (121) of the silicon body (120) through the body well layer into the epitaxial layer (EPI), the gate (G) trench (130) being insulated from the body well layer and the epitaxial layer (EPI) with a gate (G) oxidation layer (GOX), wherein the gate (G) trench (130) is formed of two stacked gate (G) trench (130) segments (Poli1, Poli2) isolated from each other by means of a gate (G) oxidation layer, each stacked gate (G) trench (130) segment being electronically connected to a respective gate (G) terminal.

The disclosure also describes a method of manufacturing such silicon chip package structure.

## Description

### TECHNICAL FIELD

The disclosure relates to a silicon chip package structure in particular a structure for metal-oxide-semiconductor field-effect transistor (MOSFET) and a method of manufacturing a silicon chip package structure in particular a metal-oxide-semiconductor field-effect transistor (MOSFET).

### BACKGROUND OF THE DISCLOSURE

Wafer level chip-scale packaging yields a semiconductor package having dimensions similar to or slightly larger than a semiconductor die. Generally, the semiconductor packages are formed on a wafer having a plurality of semiconductor dies and then diced from the wafer into individual packages.

In the case of the Chip Silicon Package (CSP), the source and the gate contact areas are usually on the front side of the chip while the drain is on a metalized backside of the chip. In power MOSFET wafer level chip-scale packages, the drain must be extended to the front side of the chip or a common drain structure including two dies may be used, so that solder balls for electrical connection to a printed circuit board can be formed on metal pads on the same front side of a chip. However, in each case, the metalized backside is still necessary.

In known CSP single side products, dedicated active area was sacrificed to create a drain area. As a result the Rdson is sacrificed. In order to overcome this drawback a new novel gate design and redistribution layer approach is suggested.

### SUMMARY OF THE DISCLOSURE

Various example embodiments are directed to issues such as those addressed above and/or others which may become apparent from the following disclosure concerning improving the CSP structure by reducing the active area needed to sacrifice to create a drain (D) area.

In certain example embodiments, aspects of the present disclosure relate to a silicon chip package structure in particular to a metal-oxide-semiconductor field-effect transistor (MOSFET), the silicon chip package structure comprising: a silicon substrate having a first substrate surface side and a second substrate surface side opposite to the first substrate surface side, a silicon body having a first body surface side and a second body surface side opposite to the first body surface side, and provided with its second body surface side to the first substrate surface side of the silicon substrate, the silicon body comprising an epitaxial layer (EPI) at its second body surface side functioning as a channel and a body well layer at its first body surface side functioning as a drift region, at least one drain (D), at least one source (S) and at least one gate (G), wherein the source (S) and the drain (D) are provided at the first body surface side of the silicon body and the gate (G) is formed as a trench positioned between the source (S) and the drain (D) and extending from the first body surface side of the silicon body through the body well layer into the epitaxial layer (EPI), the gate (G) trench being insulated from the body well layer and the epitaxial layer (EPI) with a gate (G) oxidation layer (GOX), wherein the gate (G) trench is formed of two stacked gate (G) trench segments (Poli1, Poli2) isolated from each other by means of a gate (G) oxidation layer, each stacked gate (G) trench segment being electronically connected to a respective gate (G) terminal.

In a preferred example, the silicon chip package preferably comprises at least n drain (D) terminals and at least n source (S) terminals alternately positioned relative to each other, thereby forming at least n sets of pairs of one drain (D) and one source (S) and at least n stacked gate (G) trenches, each stacked gate (G) trench positioned between alternating drains and sources, with n being 2 or more.

In a further example, seen in a direction parallel to a longitudinal orientation of the gate (G) trench, the gate (G) terminal of one stacked gate (G) trench segment extends at a further distance from the gate (G) trench compared to the gate (G) terminal of the other stacked gate (G) trench segment.

In particular, the silicon chip package structure preferably further comprises at least a layer of isolating material comprising a conductive material circuit pattern comprising circuit section connected to the trench gate (G), the source (S) and the drain (D) accordingly.

Preferably, for connectivity reasons, the second side of the silicon substrate is connected to ground potential (GND).

In a preferred example of the silicon chip package structure according to the disclosure the gate (G) is made from a polysilicon material.

Alternatively, a thickness of the gate (G) oxidation layer insulating the stacked gate (G) trench segment closest to the first body surface side of the silicon body is thicker than a thickness of the gate (G) oxidation layer insulating the other stacked gate (G) trench segment furthest to the first body surface side of the silicon body (120) .

According to an example of the disclosure a method of manufacturing a silicon chip package structure, in particular a metal-oxide-semiconductor field-effect transistor (MOSFET) is provided, the method comprising the steps of:
a. providing a silicon substrate having a first substrate surface side and a second substrate surface side opposite to the first substrate surface side;
b. providing a semiconductor epitaxial layer (EPI) on the first substrate surface side of the silicon substrate;
c. pad oxide forming a SiO₂ layer on the epitaxial layer (EPI);
d. providing a body well layer on the semiconductor epitaxial layer (EPI);
e. forming of N-well (N) and P-well (P);
f. providing thermal treatment;
g. applying hard mask treatment (HM);
h. forming a gate (G) trench (130) through etching;
i. performing first self-aligning contacts (SAC) oxidation;
j. removing first self-aligning contacts (SAC) oxidation and second self-aligning contacts (SAC) oxidation;
k. performing threshold voltage implementation (VT IMP) at the bottom of the trench;
l. removing second self-aligning contacts (SAC) oxidation and depositing a gate oxidation layer (GOX);
m. depositing and etching a first polysilicon layer of gate (G) layer (Poli1) in the trench;
n. performing local oxidation of silicon process (LOCOS);
o. depositing and etching a second polysilicon layer of gate (G) layer (Poli2) in the trench on the first polysilicon layer of gate (G) layer (Poli1);
p. depositing a source (S), a drain (D) and bulk implants on the first top of the silicon chip package structure;
q. encapsulating thereby forming the silicon chip package structure.

In particular the method according to the disclosure uses borophosphosilicate glass for the encapsulation step.

In a further detailed example of the method according to the disclosure, contacts are formulated by metal deposition followed by etching the circuit pattern.

Additionally, the step of encapsulation is repeated at least two times thereby forming a multilayer encapsulation.

In a further detailed example, the contacts in the encapsulation layer are formed by holes filled with conductive material.

According to an embodiment there is also provided an electronic active element comprising a metal base with a heat sink, a polymer body, at least two electrodes and the silicon chip package structure, wherein the source (S) terminal, the drain (D) terminal and the gate (G) terminal are connected to one of the two electrodes or the metal base accordingly, and wherein the silicon chip package structure (100) is encapsulated in the polymer body with at least a part of the electrodes and metal base being exposed.

### BRIEF DESCRIPTION OF THE DRAWINGS

The disclosure will now be discussed with reference to the drawings, which show in:
Figure 1 shows schematic cross section of a CSP product;
Figure 2 shows a schematic cross section of a CSP product with
Figure 2A depicting an one gate (G) approach
Figure 2B depicting a split gate (G) approach.
Figure 3A-3C shows schematic upper views of three possible layout implementations;
Figure 4A-4L shows a schematic representation of steps for manufacturing a CSP product according to the disclosure;
Figure 5 shows schematic cross sections of a CSP product in different locations;
Figure 6 shows schematic cross sections of a multigame CSP product;
Figure 7 shows schematic cross sections of CSP product manufacturing steps results.
Figure 8 shows schematic upper views of a CSP product in a first example, and a second example;
Figure 9 shows schematic upper views of a CSP product in a third example, and a fourth example;
Figure 10 shows a schematic upper view of a CSP product in a fifth example.

### DETAILED DESCRIPTION OF THE DRAWINGS

In certain examples, aspects of the present disclosure relate to a silicon chip package (100) structure in particular to a metal-oxide-semiconductor field-effect transistor (MOSFET). The silicon chip package structure (100) relates to a silicone active electronic element having a multilayer structure, in some embodiments those layers can be formed by different materials or by the same material with different structural characteristics or dopants.

In some examples, different layers can be formed with the same material having same structure and same dopants (or no dopants at all) but those layers are deposited in fewer steps of the same depositing process (PVD, CVD and others known epitaxial layer (EPI) deposition methods) or using different depositing processes.

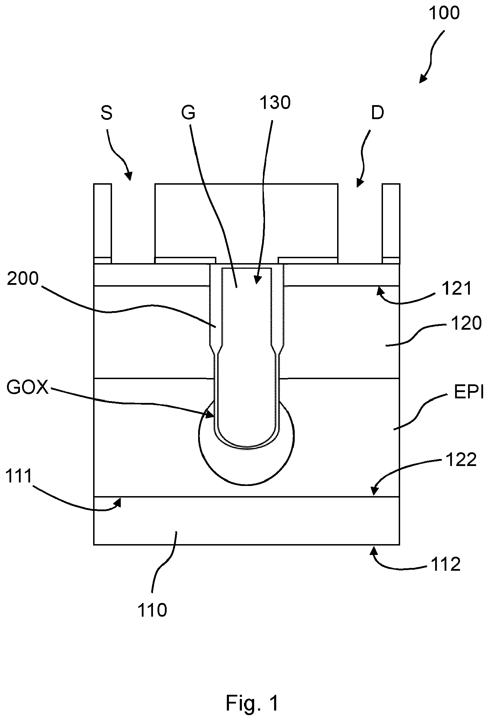

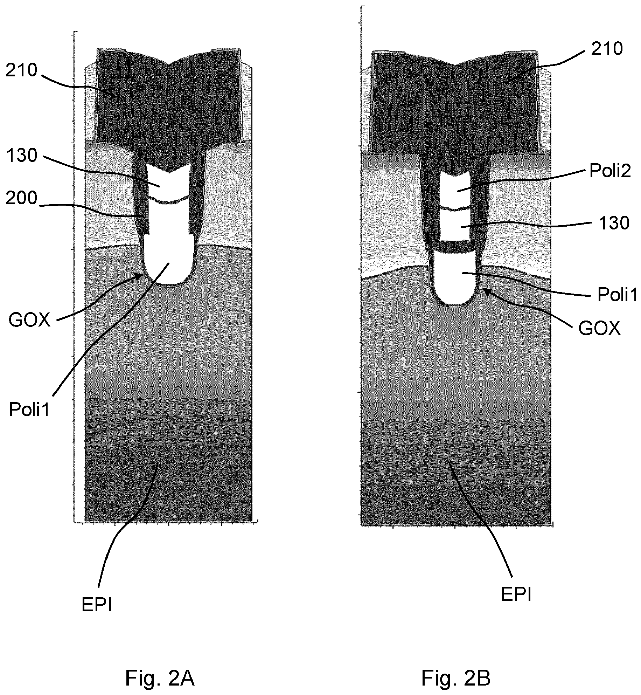

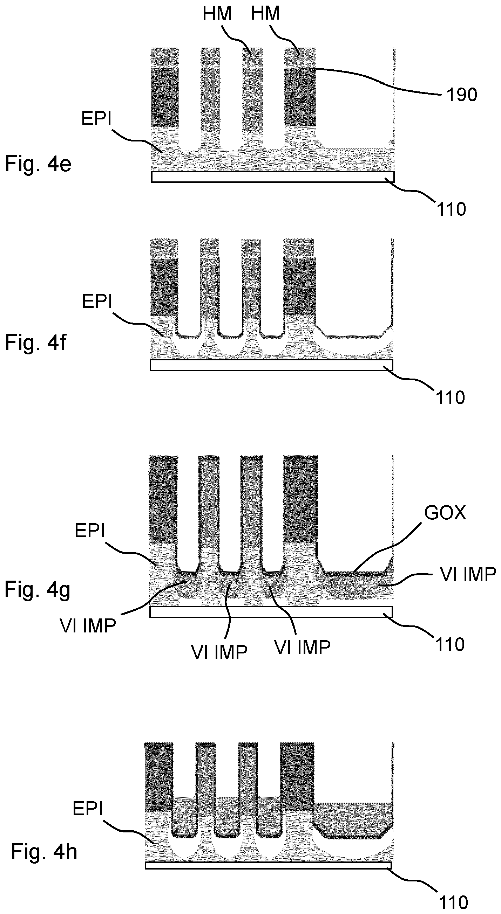

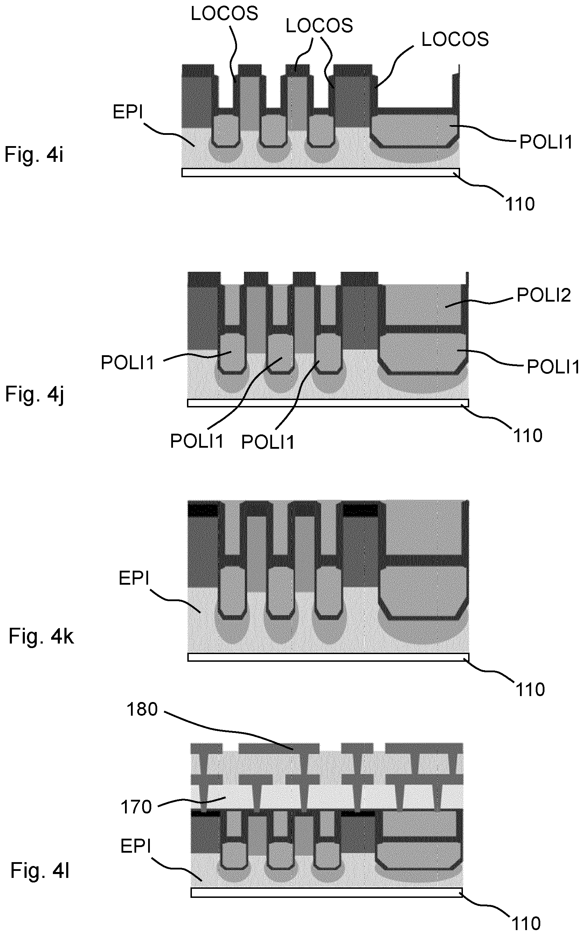

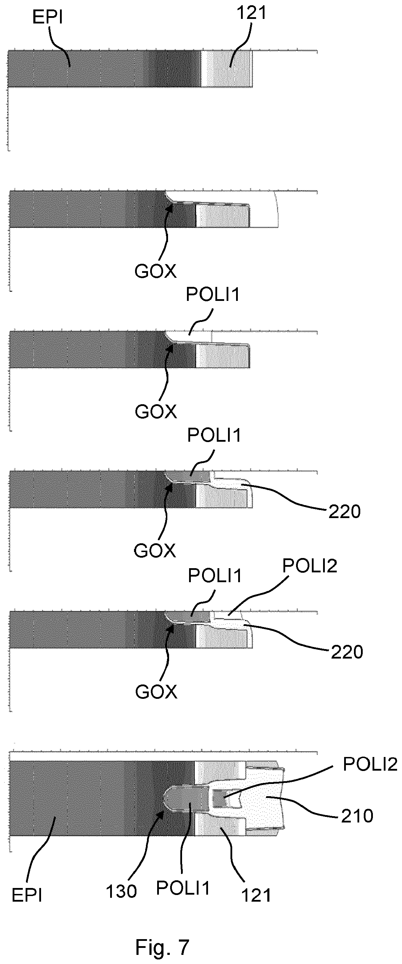

In a particular example (Figure 1 and Figures 2A-2B) the silicon chip package structure (100) comprises a silicon substrate (110) having a first substrate surface side (111) and a second substrate surface side (112) opposite to the first substrate surface side (111). The silicon chip package (100) structure further comprises a silicon body (120) having a first body surface side (121) and a second body surface side (122) opposite to the first body surface side (121), and provided with its second body surface side (122) to the first substrate surface side (111) of the silicon substrate (110), the silicon body (120) comprising an epitaxial layer (EPI) at its second body surface side (122) functioning as a channel and a body well layer at its first body surface side (121) functioning as a drift region. Reference numeral (200) denotes a field oxide layer which is a relatively thick oxide (typically 100 - 500 nm) formed to passivate and protect the semiconductor surface outside of the active device area. This layer (200) is formed during the LOCOS process, described in more detail with reference to the step performed in Figure 4i. In Figures 2A-2B and 7 reference numeral (210) may denote an ILD layer (or Inter Level Dielectric layer) used to electrically separate or shield closely spaced interconnect lines. Similarly, in the Figures reference numeral (220) denotes a shield oxide layer.

The second side (112) of the silicon substrate (110) can be connected to ground potential (GND).

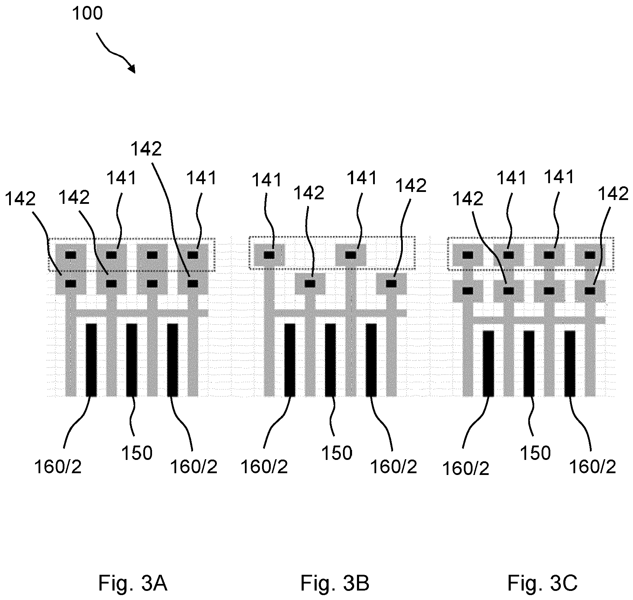

At least one drain (D), at least one source (S) and at least one gate (G) is provided, wherein the source (S) and the drain (D) are provided at the first body surface side (121) of the silicon body (120) and the gate (G) is formed as a trench (130) positioned between the source (S) and the drain (D) and extending from the first body surface side (121) of the silicon body (120) through the body well layer into the epitaxial layer (EPI), the gate (G) trench (130) being insulated from the body well layer and the epitaxial layer (EPI) with a gate (G) oxidation layer (GOX). See Figure 2A for a cross section of the example outlined above, as well as Figures 3A and 3C.

Figure 2B discloses another example according to the disclosure, wherein the gate (G) trench (130) is formed of two stacked gate (G) trench segments (Poli1, Poli2) isolated from each other by means of a gate (G) oxidation layer (GOX). Each stacked gate (G) trench (130) segment can be electronically connected to a respective gate (G) terminal (141,142). See also Figure 3B.

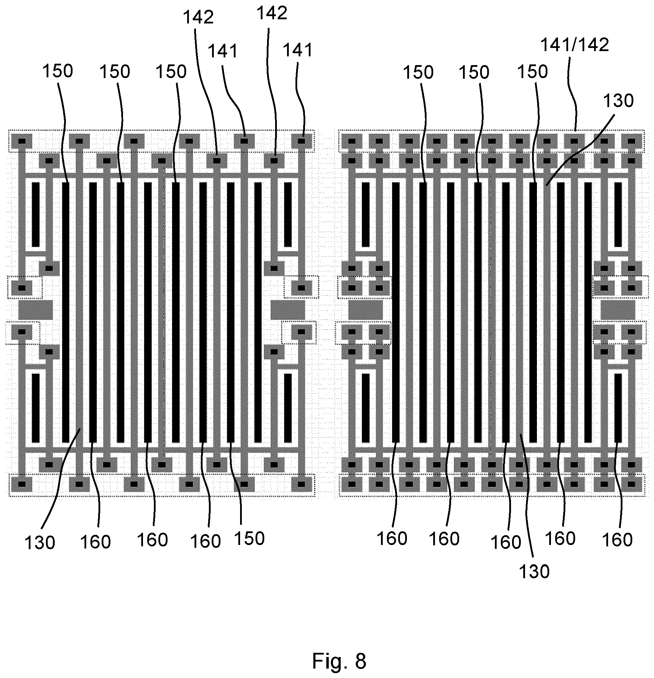

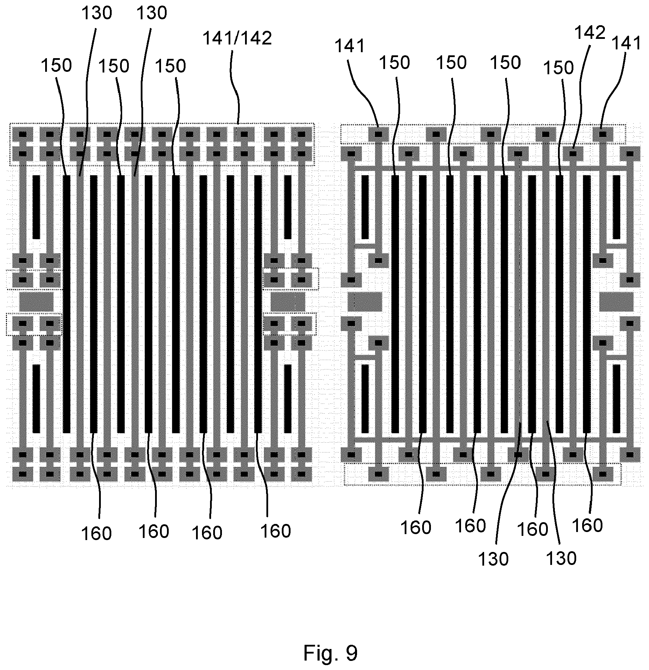

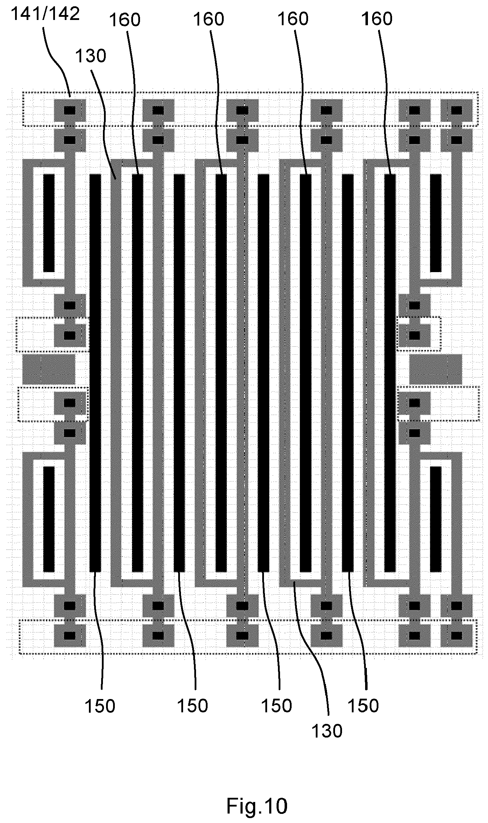

The silicon chip package (100) preferably comprises at least n drain (D) terminals (150) and at least n source (S) terminals (160) which are alternately positioned relative to each other. See Figures 3A-3C, Figure 6, Figure 8-10. Accordingly, these configurations as shown in the Figures form at least n sets of pairs of one drain (D, 150) and one source (S, 160) and at least n stacked gate (G) trenches (130), wherein each stacked gate (G) trench (130) is positioned between alternating drains (D, 150) and sources (S, 160).

It is noted, that the number n of sets of drain terminals and source terminals is at least two, and preferably 2 or more.

As shown in the drawings (Figures 3, 5, 8-10), the gate (G) terminal (141, 142) of one stacked gate (G) trench (130) segment extends, seen in a direction parallel to a longitudinal orientation of the gate (G) trench (130), at a further distance from the gate (G) trench (130) compared to the gate (G) terminal (141, 142) of the other stacked gate (G) trench (130) segment.

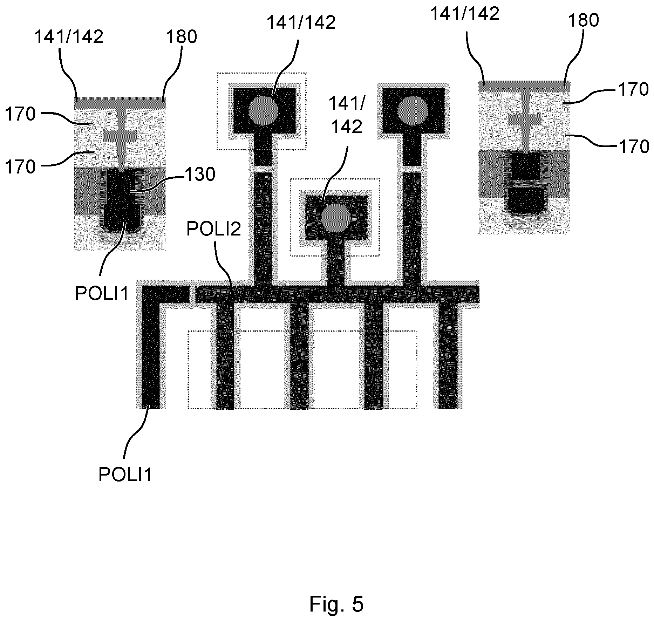

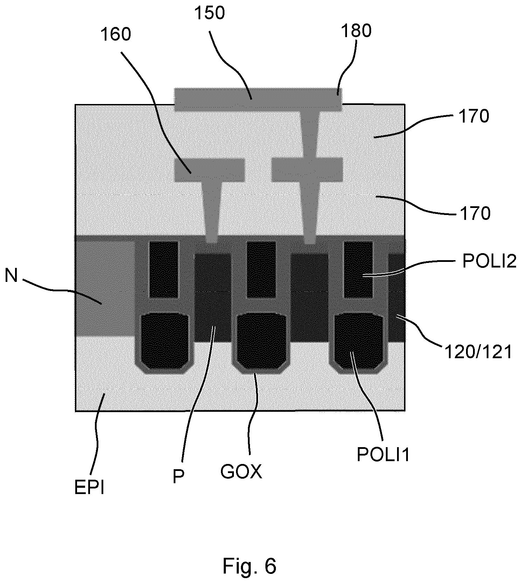

As depicted in Figures 5 and 6, the silicon chip package structure (100) may comprise at least a layer of isolating material (170). The layer of isolating material (170) comprises a conductive material circuit pattern (180) comprising a circuit section which is connected to the trench gate (G), the source (S, 160) and the drain (D, 150).

Suitable materials of the gate (G) comprises a polysilicon material.

As clearly shown in Figure 1, it should be noted that the thickness of the gate (G) oxidation layer (GOX) which is insulating the stacked gate (G) trench (130) segment closest to the first body surface side (121) of the silicon body (120) is thicker than a thickness of the gate (G) oxidation layer (GOX) insulating the other stacked gate (G) trench (130) segment furthest to the first body surface side (121) of the silicon body (120), in fact closer to the second body surface side (122) of the silicon body (120). The gate structure with the thin GOX layer acts as a channel and the gate structure with thicker oxide acts as a drift to sustain breakdown voltage (BVDSS).

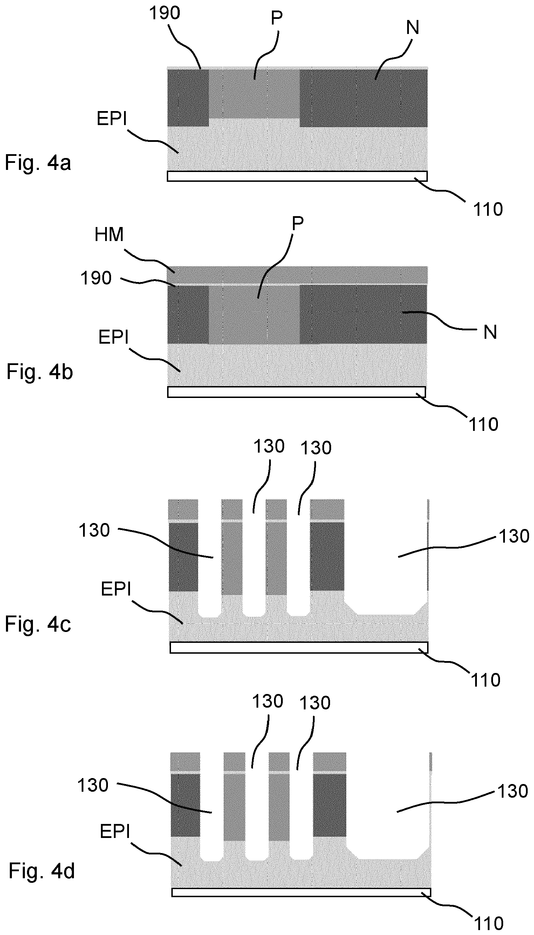

The method of manufacturing a silicon chip package structure (100) in particular a metal-oxide-semiconductor field-effect transistor (MOSFET) according to the disclosure is depicted in Figures 4a-4l, the method comprising the steps of:
a. in Figure 4a, providing a silicon substrate (110) having a first substrate surface side (111) and a second substrate surface side (112) opposite to the first substrate surface side;
b. in Figure 4a, providing a semiconductor epitaxial layer (EPI) on the first substrate surface side (111) of the silicon substrate (110);
c. in Figure 4a, forming a SiO₂ (190) layer on the epitaxial layer (EPI);
d. in Figure 4a, providing a guard ring on the semiconductor epitaxial layer (EPI);
e. in Figure 4a, forming of N-well (N) and P-well (P) ;
f. providing thermal treatment;
g. in Figure 4b, applying hard mask treatment (HM);
h. in Figure 4c, forming a gate (G) trench (130) through etching;
i. in Figures 4d-4e performing first self-aligning contacts (SAC) oxidation;
j. in Figures 4d-4e removing first self-aligning contacts (SAC) oxidation and second self-aligning contacts (SAC) oxidation;
k. in Figures 4d-4e, performing threshold voltage implementation at the bottom of the trench forming a threshold voltage implementation region (VT IMP);
l. in Figure 4f-4g, removing second self-aligning contacts (SAC) oxidation and depositing a gate (G) oxidation layer (GOX);
m. in Figure 4h, depositing and etching a first polysilicon layer of gate (G) layer (Poli1) in the trench;
n. in Figure 4i, performing local oxidation of silicon process forming a local oxidation of silicon layer (LOCOS), also denoted as a field oxide layer (200) see Figure 1;
o. in Figure 4j-4k, depositing and etching a second polysilicon layer of gate (G) layer (Poli2) in the trench on the first polysilicon layer of gate (G) layer (Poli1);
p. in Figure 4l depositing a source (S), a drain (D) and bulk implants on the first surface of the silicon chip package structure (100);
q. finally, encapsulating thereby forming the silicon chip package structure (100).

In certain examples borophosphosilicate glass can be used for the step of encapsulation.

The preferred example has electric contacts which are formed by metal deposition followed by the step of etching a circuit pattern. In a preferable example the step of encapsulation is repeated at least two times thereby forming a multilayer encapsulation. Further improved encapsulation can be achieved by repeating the encapsulation step preferably 3 or even 4 times.

The contacts in the encapsulation layer are formed by holes which may be filled with a conductive material, such as tungsten or any Al compound (Al, AISi, AlCu, AlSiCu).

According to an example, the drawings also depict an electronic active element obtained with the method according to the disclosure. The electronic active element comprises a metal base with a heat sink, a polymer body, at least two electrodes and the silicon chip package structure (100) according to the disclosure. As shown in the drawings, the source (S) terminal (160), the drain (D) terminal (150) and the gate (G) terminal (141, 142) are connected to one of the two electrodes or the metal base. The silicon chip package structure (100) is encapsulated in the polymer body with at least a part of the electrodes and metal base being exposed.

The gate oxide layer (GOX) is the dielectric layer that separates the gate terminal of a MOSFET (metal-oxide-semiconductor field-effect transistor) from the underlying source and drain terminals as well as the conductive channel that connects source and drain when the transistor is turned on. The gate oxide layer (GOX) may be formed by thermal oxidation of the silicon of the channel in order form a thin insulating layer of silicon dioxide (SAC) having a thickness of 5 - 200 nm. The insulating silicon dioxide layer is formed through a process of self-limiting oxidation. A conductive gate material is subsequently deposited over the gate oxide to form the transistor.

LOCOS, short for LOCal Oxidation of Silicon, is a microfabrication process where silicon dioxide is formed in selected areas on a silicon wafer having the Si-SiO2 interface at a lower point than the rest of the silicon surface. In the process a silicon oxide insulating structure is fabricated as a field oxide layer (200), see Figure 1, so that the Si-SiO₂ interface occurs at a lower point than the rest of the silicon surface. The oxygen penetrates in depth of the wafer, reacts with silicon and transforms it into silicon oxide.

Self-Aligned Contact (SAC) denotes a semiconductor process flow technique that adds a protective dielectric layer over the transistor gate in order to prevent contact-to-gate shorts. SAC is used to enable aggressive scaling of the contacted poly pitch while minimizing yield loss due to misalignment and partial overlaps of the contacts over the gate.

### LIST OF REFERENCE NUMERALS

- 100: silicon chip package structure
- 110: silicon substrate
- 111: first substrate surface side
- 112: second substrate surface side
- 120: silicon body
- 121: first body surface side
- 122: second body surface side
- 130: gate trench
- 141, 142: gate (G) terminal
- 150: drain (D) terminal
- 160: source (S) terminal
- 170: layer of isolating material
- 180: conductive material circuit pattern
- 200: field oxide layer
- 210: ILD / Inter Level Dielectric layer
- 220: shield oxide layer

## Claims

1. A silicon chip package structure (100) in particular a metal-oxide-semiconductor field-effect transistor (MOSFET), the silicon chip package structure (100) comprising:
- a silicon substrate (110) having a first substrate surface side (111) and a second substrate surface side (112) opposite to the first substrate surface side (111),
- a silicon body (120) silicon body (120) having a first body surface side (121) and a second body surface side (122) opposite to the first body surface side (121), and provided with its second body surface side (122) to the first substrate surface side (111) of the silicon substrate (110), the silicon body (120) comprising an epitaxial layer (EPI) at its second body surface side (122) functioning as a channel and a body well layer at its first body surface side (121) functioning as a drift region,
at least one drain (D), at least one source (S) and at least one gate (G), wherein the source (S) and the drain (D) are provided at the first body surface side (121) of the silicon body (120) and the gate (G) is formed as a trench (130) positioned between the source (S) and the drain (D) and extending from the first body surface side (121) of the silicon body (120) through the body well layer into the epitaxial layer (EPI), the gate (G) trench (130) being insulated from the body well layer and the epitaxial layer (EPI) with a gate (G) oxidation layer (GOX), wherein the gate (G) trench (130) is formed of two stacked gate (G) trench (130) segments (Poli1, Poli2) isolated from each other by means of a gate (G) oxidation layer, each stacked gate (G) trench (130) segment being electronically connected to a respective gate (G) terminal.

2. The silicon chip package structure (100) according to claim 1, comprising at least n drain (D) terminals (150) and at least n source (S) terminals (160) alternately positioned relative to each other, thereby forming at least n sets of pairs of one drain (D) and one source (S) and at least n stacked gate (G) trench (130)es, each stacked gate (G) trench (130) positioned between alternating drain (D) s and source (S)s, with n being 2 or more.

3. The silicon chip package structure (100) according to claim 1 or 2, wherein, seen in a direction parallel to a longitudinal orientation of the gate (G) trench (130), the gate (G) terminal (141, 142) of one stacked gate (G) trench (130) segment extends at a further distance from the gate (G) trench (130) compared to the gate (G) terminal (141, 142) of the other stacked gate (G) trench (130) segment.

4. The silicon chip package structure (100) according to any one or more of the preceding claims, further comprising at least a layer of isolating material comprising (170) a conductive material circuit pattern (180) comprising circuit section connected to the trench (130) gate (G), the source (S) and the drain (D) accordingly.

5. The silicon chip package structure (100) according to any one or more of the previous claims, wherein the second side (112) of the silicon substrate (110) is connected to ground potential (GND).

6. The silicon chip package structure (100) according to any one or more of the previous claims, wherein the gate (G) is made from a polysilicon material.

7. The silicon chip package structure (100) according to any one or more of the previous claims, wherein a thickness of the gate oxidation layer (GOX) insulating the stacked gate (G) trench (130) segment closest to the first body surface side (121) of the silicon body (120) is thicker than a thickness of the gate oxidation layer (GOX) insulating the other stacked gate (G) trench (130) segment furthest to the first body surface side (121) of the silicon body (120) .

8. A method of manufacturing a silicon chip package structure (100) in particular a metal-oxide-semiconductor field-effect transistor (MOSFET) according to any of previous claims, the method comprising the steps of:
a. providing a silicon substrate (110) having a first substrate surface side (111) and a second substrate surface side (112) opposite to the first substrate surface side (111);
b. providing a semiconductor epitaxial layer (EPI) on the first substrate surface side (111) of the silicon substrate (110);
c. pad oxide forming a SiO₂ layer (190) on the epitaxial layer (EPI);
d. providing a body well layer on the semiconductor epitaxial layer (EPI);
e. forming of N-well (N) and P-well (P);
f. providing thermal treatment;
g. applying hard mask treatment (HM);
h. forming a gate (G) trench (130) through etching;
i. performing first self-aligning contacts (SAC) oxidation;
j. removing first self-aligning contacts (SAC) oxidation and second self-aligning contacts (SAC) oxidation;
k. performing threshold voltage implementation (VT IMP) at the bottom of the trench (130);
l. removing second self-aligning contacts (SAC) oxidation and depositing a gate (G) oxidation layer (GOX);
m. depositing and etching a first polysilicon layer of gate (G) layer (Poli1) in the trench (130);
n. performing local oxidation of silicon process (LOCOS);
o. depositing and etching a second polysilicon layer of gate (G) layer (Poli2) in the trench (130) on the first polysilicon layer of gate (G) layer (Poli1);
p. depositing a source (S), a drain (D) and bulk implants on the first top of the silicon chip package structure (100);
q. encapsulating thereby forming the silicon chip package structure (100).

9. The method according to claim 8 wherein borophosphosilicate glass is used for encapsulation.

10. The method according to claim 8 or 9, wherein contacts are formulated by metal deposition followed by etching circuit pattern.

11. The method according to any one or more of the claims 8-10, wherein the step of encapsulation is repeated at least two times thereby forming a multilayer encapsulation.

12. The method according to any one or more of the claims 8-11, wherein the contacts in the encapsulation layer are formed by holes filled with conductive material.

13. An electronic active element comprising a metal base with a heat sink, a polymer body, at least two electrodes and the silicon chip package structure (100) according to any of the claims 1-7, wherein the source (S) terminal (160), the drain (D) terminal (150) and the gate (G) terminal (141, 142) are connected to one of the two electrodes or the metal base accordingly, and wherein the silicon chip package structure (100) is encapsulated in the polymer body with at least a part of the electrodes and metal base being exposed.
